# EUROPÄISCHE PATENTSCHRIFT

(11) **EP 3 106 362 B1**
(45) Veröffentlichungstag und Bekanntmachung des Hinweises auf die Patenterteilung: **16.02.2022**
(21) Anmeldenummer: 16001156.5
(22) Anmeldetag: 20.05.2016
(51) Int. Cl.: B60W 20/12, B60W 50/00, B60W 10/06, B60W 10/26

(54) **VERFAHREN ZUR ONLINE-ADAPTION EINER KENNLINIE EINES HYBRIDFAHRZEUGS**
METHOD FOR ONLINE ADAPTATION OF A CHARACTERISTIC CURVE OF A HYBRID VEHICLE
PROCEDE D'ADAPTATION EN LIGNE D'UNE COURBE CARACTERISTIQUE D'UN VEHICULE HYBRIDE

(30) Priorität: 20.06.2015 DE 102015007913
(43) Veröffentlichungstag der Anmeldung: 21.12.2016
(73) Patentinhaber: MAN Truck & Bus SE, 80995 München (DE)
(72) Erfinder: Nuber, Johannes, 85748 Garching bei München (DE); Kirchensteiner, Elmar, 85256 Vierkirchen (DE); Günnewicht, Manuel, 85652 Pliening (DE); Hierlmeier, Matthias, 80997 München (DE); Ovari, Sebastian, 85241 Hebertshausen (DE)
(74) Vertreter: v. Bezold & Partner Patentanwälte - PartG mbB

(56) Entgegenhaltungen:
- DE-A1-102007 020 196
- DE-A1-102010 005 837
- DE-A1-102010 029 443
- DE-A1-102011 080 758
- US-A1- 2009 250 277

## Beschreibung

Die Erfindung betrifft ein Verfahren zur Online-Adaption einer Kennlinie eines Hybridfahrzeugs, wobei die Kennlinie zur Auswahl einer Betriebsart und/oder zur Bestimmung eines Betriebspunktes des hybridisierten Antriebsstrangs des Hybridfahrzeugs verwendet wird.

Stetig steigende Kraftstoffkosten sowie strengere gesetzliche Vorgaben betreffend die Fahrzeugemissionen stellen immer höhere Anforderungen an die Effizienz von Kraftfahrzeugen. Ein großes Potential zur Reduzierung des Kraftstoffverbrauchs stellt die Hybridisierung des Antriebsstrangs dar. Dabei wird der Antriebsstrang um mindestens eine elektrische Maschine und ein zugeordnetes elektrisches Speichersystem erweitert.

Je nach Ausführung der Hybridisierung können damit neben einem rein verbrennungsmotorischen Betrieb verschiedene weitere Betriebsarten, wie elektrisches Fahren, ein Boost-Betrieb, eine Bremsrekuperation, eine Lastpunktverschiebung etc. dargestellt werden. Eine Betriebsart ist durch die Kombination einer spezifischen Komponentenkonfiguration und der Form der Energieflüsse in den beteiligten Komponenten eines Antriebsstrangs charakterisiert.

Die verschiedenen Betriebsarten eines hybridisierten Antriebsstrangs müssen im Fahrzeugbetrieb sinnvoll eingesetzt werden, um eine größtmögliche Reduzierung des Kraftstoffverbrauchs zu erreichen. Dabei sollen auch weitere Ziele bzw. Zielkriterien beachtet werden, da die Steigerung der Verbrauchseffizienz stets im Spannungsfeld zwischen Emissionsminimierung, Komponentenschutz und/oder Fahrkomfort stattfindet. Es daher erforderlich, im Rahmen einer übergeordneten Betriebsstrategie aus einer vorgegebenen Menge möglicher Betriebsarten des hybridisierten Antriebsstrangs eine für den aktuellen Betriebszeitpunkt hinsichtlich der vorgegebenen Zielkriterien optimale Betriebsart mit einer korrespondierenden optimalen Leistungsverteilung im Antriebsstrang auszuwählen.

Zur Auswahl einer jeweils optimalen Betriebsart im Rahmen einer Betriebsstrategie sind aus dem Stand der Technik verschiedene Techniken und Methoden bekannt. Beispielhaft wird hierzu auf die folgenden Veröffentlichungen aus dem Stand der Technik verwiesen:
[1]: A. Wilde, Eine modulare Funktionsarchitektur für adaptives und vorausschauendes Energiemanagement in Hybridfahrzeugen, Dissertation, TU München, 2009; und
[2]: J. von Grundherr, Ableitung einer heuristischen Betriebsstrategie für ein Hybridfahrzeug aus einer Online-Optimierung, Dissertation, TU München, 2010; und
[3]: Onori et al., Adaptive Equivalent Consumption Minimization Strategy for Hybrid Electric Vehicles, Proceedings of the ASME 2010, Dynamic Systems and Control Conference DSCC2010 September 12-15, 2010, Cambridge (MA), USA.

Beispielsweise sind Methoden basierend auf sogenannten Online-Optimierungen bekannt, die das Fahrzeug als ein mehrdimensionales Optimierungsproblem verstehen, das durch eine Zielfunktion beschrieben wird, welche nicht nur physikalische Größen wie den Verbrauch, sondern auch andere Anforderungen wie die Lärmemission oder den Lebensdauerschutz von Komponenten etc. miteinbeziehen. So wird beispielsweise in der Veröffentlichung [2] eine Gesamtkostenfunktion vorgeschlagen, mittels derer neben dem Zielkriterium "Kraftstoffeffizienz" weitere Zielkriterien wie beispielsweise eine Fahrbarkeit (Fahrkomfort) berücksichtigt werden. Hierbei werden Teilkostenfunktionen korrespondierend zu den einzelnen Zielkriterien zu einer Gesamtkostenfunktion mittels einer Summierung kombiniert und dann die Entscheidung betreffend die Betriebsstrategie aus der Gesamtkostenfunktion berechnet.

Für jedes der vorgegebenen Zielkriterien wird vorab wenigstens eine Bewertungsvariable zur quantitativen Beschreibung des jeweiligen Zielkriteriums festgelegt bzw. bestimmt. Zur Berechnung der Bewertungsvariablen und zur Modellierung der Kostenfunktionen werden in der Regel mehrere Kennlinien verwendet.

Vor allem bei vielen Zielkriterien, die eine Betriebsstrategie berücksichtigen muss, ist die Applizierung eines Betriebsartauswahlverfahrens aufgrund der vielen Kennlinien mit zahlreichen Abhängigkeiten aufwändig.

Ferner wird die Applizierung einer Betriebsstrategie in der Regel nur für einen einzigen geplanten Fahrzeugeinsatz vorgenommen. Zumeist ergeben sich jedoch Abweichungen zwischen dem geplanten und dem tatsächlichen Fahrzeugeinsatz. Es wäre daher wünschenswert, diese Abweichungen im Betrieb des Fahrzeugs zu erkennen und die Betriebsstrategie entsprechend anzupassen. Mithilfe derartiger Abweichungsdaten könnten die Kennlinien der Betriebsstrategie online adaptiert werden, d. h. im Fahrbetrieb des Fahrzeugs dynamisch angepasst werden, was bei steigender Abhängigkeit der Kennlinien untereinander jedoch dementsprechend schwer umsetzbar ist und/oder hohe Rechenaufwände erfordert. Ferner können in der Betriebsstrategie vorausschauende Informationen verarbeitet werden, um auf veränderte Randbedingungen zu reagieren, den Energiespeicher auf zukünftige Ereignisse vorzukonditionieren und somit die maximale Zielerreichung sicherzustellen. Auch dies erfordert eine Online-Adaption der Kennlinien.

Aus der DE 10 2007 020 196 A1, auf welcher die zweiteilige Anspruchsfassung basiert, ist ein Verfahren zur Regelung des Ladezustands eines Energiespeichers für ein Fahrzeug mit Hybridantrieb bekannt, das sich für Energiespeicher mit kleiner maximaler Energiespeicherkapazität eignet und bei dem anhand einer den Ladezustand festlegenden Kennlinie Ist-Ladezustand des Speichers stets auf den Soll-Ladezustand zurückgeführt wird. Aus der Offenlegungsschrift DE 10 2010 029 443 A1 ist ein Verfahren zum Betreiben eines Antriebsstrangs bekannt, wobei ein Ladezustand eines elektrischen Energiespeichers zwischen einem oberen und unteren Grenzwert variiert, wobei die Grenzwerte abhängig von der kinetischen Bewegungsenergie des Kraftfahrzeugs oder abhängig von der potentiellen Lageenergie des Kraftfahrzeugs verändert wird.

Es ist somit eine Aufgabe der Erfindung, ein verbessertes Verfahren zur Online-Adaption einer Kennlinie eines Hybridfahrzeugs, wobei die Kennlinie zur Auswahl einer Betriebsart und/oder zur Bestimmung eines Betriebspunktes des hybridisierten Antriebsstrangs des Hybridfahrzeugs verwendet wird, bereitzustellen, mit dem Nachteile herkömmlicher Techniken vermieden werden können. Die Aufgabe der Erfindung ist es insbesondere, ein vereinfachtes Verfahren zur Online-Adaption einer Kennlinie eines Hybridfahrzeugs bereitzustellen, das sich durch eine geringere Komplexität auszeichnet und mit dem eine Vielzahl von Kennlinien mit vergleichsweise geringem Rechenaufwand online adaptiert werden können, insbesondere aufgrund veränderter Randbedingungen oder auf Basis von vorausschauenden Informationen.

Diese Aufgaben werden durch ein Verfahren und eine Vorrichtung mit den Merkmalen der unabhängigen Ansprüche gelöst. Vorteilhafte Ausführungsformen der Erfindung ergeben sich aus den abhängigen Ansprüchen und werden in der folgenden Beschreibung unter teilweiser Bezugnahme auf die Figuren näher erläutert.

Gemäß einem ersten Gesichtspunkt der Erfindung wird ein Verfahren zur Online-Adaption mindestens einer Kennlinie eines Hybridfahrzeugs, aufweisend einen hybridisierten Antriebsstrang mit einem elektrischen Antrieb, welcher aus einem elektrischen Energiespeicher mit Strom speisbar ist, bereitgestellt. Die mindestens eine Kennlinie wird hierbei zur Auswahl einer Betriebsart und/oder zur Bestimmung eines Betriebspunktes des hybridisierten Antriebsstrangs verwendet.

Unter dem Begriff einer "Online-Adaption" wird eine Anpassung der Kennlinie im Betrieb bzw. Fahrbetrieb des Hybridfahrzeugs verstanden, so dass der Verlauf der Kennlinie im Fahrbetrieb beispielsweise an veränderte Randbedingungen oder im Hinblick auf vorausschauende Streckeninformationen angepasst werden kann.

Gemäß dem erfindungsgemäßen Verfahren werden mehrere Unterteilungsgrenzen festgelegt, mittels derer ein Ladezustandsbereich des Energiespeichers in mehrere Bereiche unterteilt werden kann, wobei zumindest eine der Unterteilungsgrenzen im Betrieb des Fahrzeugs variabel festlegbar ist.

Der Ladezustandsbereich des Energiespeichers umfasst in der Regel einen Ladezustand (engl. State of Charge (SOC)) von 0% bis 100%. Eine Ladezustandsgrenze kann durch einen Ladezustandswert festgelegt sein, beispielsweise durch einen SOC-Wert von x %. Bei einer variabel festlegbaren Unterteilungsgrenze kann der Ladezustandswert x % im Fahrbetrieb des Fahrzeugs verändert werden, so dass sich die Position der Unterteilungsgrenze verändert, d. h. sich entlang der Ladezustandsachse nach links oder rechts verschiebt.

Gemäß dem erfindungsgemäßen Verfahren wird der Verlauf der mindestens einen Kennlinie in Abhängigkeit von einem Ladezustand des Energiespeichers vorgegeben, wobei die Werte der mindestens einen Kennlinie an den Unterteilungsgrenzen fest vorgegeben werden. Mit anderen Worten werden die Ordinaten der Kennlinie an den Stellen der Unterteilungsgrenzen festgelegt, unabhängig davon, auf welchen momentanen Ladezustandswert (Abszisse) die Unterteilungsgrenzen momentan eingestellt sind. Der vorgegebene Verlauf einer Kennlinie wird somit durch mehrere Teilverläufe gebildet, die sich jeweils von einer Unterteilungsgrenze zu einer hierzu benachbarten Unterteilungsgrenze erstrecken, wobei die Ordinaten der Randpunkte der Teilverläufe, die immer auf den Unterteilungsgrenzen liegen, fix sind. Jeder Teilverlauf wird somit durch seine Randpunkte und die Funktion bzw. Kurvenform des jeweiligen Teilverlaufs vorgeben, um die Randpunkte zu verbinden. Bei einer variablen Unterteilungsgrenze ist die Position des auf der Unterteilungsgrenze liegenden Randpunkts in Abszissenrichtung (d. h. Ladezustandsachse) somit abhängig von der aktuellen Position der Unterteilungsgrenze. Beispielsweise kann die Kurvenform eines Teilverlaufs als linear, parabelförmig, hyperbelförmig etc. vorgeben werden.

Mathematisch gesprochen wird somit die Funktion, die einem Ladezustandswert einen Kennlinienwert zuordnet, vorgegeben, mit den Randbedingungen, dass die Kennlinie an den Unterteilungsgrenzen immer die vorgegebenen festen Werte aufweist. Dadurch wird in Abhängigkeit von den momentanen Werten der Unterteilungsgrenzen eine Schar möglicher Teilverläufe und damit eine Schar möglicher Kennlinienverläufe vorgeben, wobei durch Festlegung der Werte für die Unterteilungsgrenzen auch der Verlauf der Kennlinie eindeutig festgelegt ist.

Wie im Einzelfall der Kennlinienverlauf unter Berücksichtigung der vorstehenden Ausführungen vorgegeben wird, hängt natürlich von der technischen Bezugsgröße ab, die die Kennlinie abbildet, und ist nicht Gegenstand der Erfindung.

Gemäß dem erfindungsgemäßen Verfahren erfolgt eine Online-Adaption der mindestens einen Kennlinie im Falle einer Verschiebung zumindest einer der variablen Unterteilungsgrenzen. Hierbei wird die mindestens eine Kennlinie unter Berücksichtigung der fest vorgegebenen Werte, die die Kennlinie an den Unterteilungsgrenzen aufweist, und korrespondierend zu der/den verschobenen variablen Unterteilungsgrenze(n) verschoben und skaliert, so dass die Kennlinie an die verschobene(n) Unterteilungsgrenze(n) angepasst wird. Bei einer Verschiebung einer Unterteilungsgrenze "wandert" die Kennlinie somit mit der Unterteilungsgrenze mit, wobei der Verlauf der Kennlinien zwischen zwei Unterteilungsgrenzen automatisch skaliert wird. Mathematisch gesprochen wird somit auf Basis der vorgegebenen mathematischen Funktion für den Kennlinienverlauf unter Berücksichtigung der neuen Randbedingungen in Form der mit der/den Unterteilungsgrenze(n) verschobenen Randpunkte der Kennlinie der Kennlinienverlauf neu berechnet.

Die vorliegende Erfindung macht sich die Tatsache zunutze, dass jede hybride Betriebsart die elektrische Maschine verwendet und deshalb entweder ein Laden oder ein Entladen des Energiespeichers zur Folge hat. Damit kann der Ladezustand (State of Charge (SOC)) des Energiespeichers als eine zentrale Größe zur Applizierung von Betriebsstrategien verwendet werden. Erfindungsgemäß wird dies genutzt, um durch die Festlegung der Unterteilungsgrenzen eine Struktur zur Einteilung des Ladezustands des Energiespeichers bereitzustellen, anhand derer sich Kennlinien einer Betriebsstrategie orientieren können und in die die Kennlinien des Verfahrens eingepflegt werden können. Die Kennlinie muss jedoch in einem logischen Zusammenhang mit dem Ladezustand des elektrischen Energiespeichers stehen, d. h. in Abhängigkeit von dem Ladezustand festlegbar sein, was bei der Mehrzahl der Kennlinien, die zur Auswahl einer Betriebsart oder eines Betriebspunkts eines hybridisierten Antriebsstrangs typischerweise verwendet werden, der Fall ist. Die über dem Ladezustand (SOC) definierten Unterteilungsgrenzen und dadurch gebildeten Ladezustandsbereiche stellen ein Hilfsmittel dar, mit dem die Kennlinien einer Betriebsstrategie aneinander angepasst werden können. Jede Kennlinie muss sich derart an den Grenzen orientieren, dass die erwünschten Effekte der Bereiche sichergestellt werden. Dadurch haben alle Kennlinien des Verfahrens einen gemeinsamen Rahmen, an den sie angepasst werden können. Die erfindungsgemäße Aufteilung der SOC-Bereiche stellt somit eine einfache Möglichkeit dar, die Kennlinien im Fahrbetrieb dynamisch anzupassen. Dazu werden eine oder mehrere der Unterteilungsgrenzen verschoben Die dynamische Online-Anpassung der Kennlinien erfolgt durch Anpassung der Kennlinien an die verschobenen Unterteilungsgrenzen. Diese wandern mit diesen Grenzen mit und werden automatisch entsprechend skaliert. Dadurch sinkt die Komplexität bei Abhängigkeiten zwischen den Kennlinien.

Vorstehend wurde bereits erwähnt, dass der vorgegebene Verlauf einer Kennlinie durch mehrere Teilverläufe gebildet sein kann, die sich jeweils von einer Unterteilungsgrenze zu einer hierzu benachbarten Unterteilungsgrenze erstrecken. Gemäß einer bevorzugten Ausführungsform des Verfahrens ergibt sich ein adaptierter Verlauf der Kennlinie im Falle der Verschiebung zumindest einer der variablen Unterteilungsgrenzen durch eine Streckung, Stauchung und/oder Verschiebung in Abszissenrichtung derjenigen Teilverläufe, die an zumindest einer Unterteilungsgrenze enden, die verschoben wurde. Hierbei bleibt ein Randpunkt eines Teilverlaufs durch die Streckung, Stauchung und/oder Verschiebung in Abszissenrichtung der Kennlinie unverändert, falls er auf einer nicht verschobenen Unterteilungsgrenze liegt. Dagegen wird ein Randpunkt eines Teilverlaufs in Abszissenrichtung, d. h. in Richtung der Ladezustandsachse, zusammen mit der Unterteilungsgrenze verschoben, falls er auf einer verschobenen Unterteilungsgrenze liegt. Die Ordinaten (Y-Werte) der auf den Unterteilungsgrenzen liegenden Randpunkte sind, wie bereits vorstehend erwähnt wurde, fix vorgeben.

Wenn beispielsweise zwei benachbarte Unterteilungsgrenzen um den gleichen Betrag nach links oder um den gleichen Betrag nach rechts entlang der Ladezustandsachse verschoben werden, ergibt sich der adaptierte Teilverlauf der Kennlinie, der sich zwischen diesen beiden Unterteilungsgrenzen befindet, durch eine korrespondierende Verschiebung des Teilverlaufs nach links oder nach rechts - ohne Streckung oder Stauchung. Verkleinert sich der Abstand zweier benachbarter Unterteilungsgrenzen, wird der sich dazwischen erstreckende Teilverlauf der Kennlinie in Abszissenrichtung, d. h. in x-Richtung bzw. in Richtung der Ladezustandsachse, gestaucht. Vergrößert sich der Abstand zweier benachbarter Unterteilungsgrenzen, wird der sich dazwischen erstreckende Teilverlauf der Kennlinie in Abszissenrichtung gestreckt. Der Streckungsfaktor bzw. Stauchungsfaktor für die Skalierung des Teilverlaufs ergibt sich aus dem Verhältnis des Abstands benachbarter Unterteilungsgrenzen vor und nach der Verschiebung der Unterteilungsgrenzen und kann für jeden Teilverlauf unterschiedlich sein.

Der Gesamtverlauf der adaptierten Kennlinie wird somit aus den resultierenden Teilverläufen gebildet, wobei Teilverläufe, die sich zwischen zwei Unterteilungsgrenzen befinden, die beide nicht verschoben wurden, nicht angepasst werden (müssen).

Die Erfindung zeichnet sich zudem dadurch aus, dass zumindest eine der Unterteilungsgrenzen im Betrieb des Fahrzeugs fortlaufend in Abhängigkeit von Informationen, die einen vorausliegenden Streckenabschnitt kennzeichnen, angepasst wird und/oder zumindest eine der Unterteilungsgrenzen im Betrieb des Fahrzeugs fortlaufend in Abhängigkeit von topographischen Daten eines vorausliegenden Streckenabschnitts, die einen Gefälle- und Steigungsverlauf bzw. ein Höhenprofil des vorausliegenden Streckenabschnitts angeben, angepasst werden. Damit kann z. B. ein Vorhalten von elektrischer Energie oder ein vorzeitige Entleeren des Speichers für zukünftige Ereignisse dargestellt werden, falls anhand der topographischen Daten eines vorausliegenden Streckenabschnitts erkannt wird, dass sich das Fahrzeug auf eine längere Steigung oder Gefällestrecke zubewegt.

Eine weitere vorteilhafte Möglichkeit der erfindungsgemäßen Realisierung sieht vor, dass zumindest eine der Unterteilungsgrenzen im Betrieb des Fahrzeugs fortlaufend in Abhängigkeit von einem Parameter, der eine Abweichung von einem geplanten Fahrzeugeinsatz zu einem tatsächlichen Fahrzeugeinsatz angibt, angepasst wird. Die Unterteilungsgrenzen können somit angepasst werden, falls ein geplanter Fahrzeugeinsatz, für den die Applizierung der Kennlinie vorgenommen wurde, vom tatsächlichen Fahrzeugeinsatz abweicht. Beispielsweise können die lebensdaueroptimalen Untergrenzen und/oder Obergrenzen des Ladezustands, vgl. hierzu die nachfolgende Beschreibung, über den Alterungszustand der Batterie, der wiederum vom Fahrzeugeinsatz abhängt, angepasst werden. Führt beispielsweise der tatsächliche Fahrzeugeinsatz zu einem tatsächlichen Alterungszustand der Batterie, der kleiner als der erwartete Alterungszustand ist, kann die untere lebensdaueroptimale Grenze des Ladezustands näher an die untere Ladezustandsgrenze (0%-Grenze des Ladezustands) und die obere lebensdaueroptimale Grenze des Ladezustands näher an die obere Ladezustandsgrenze (100%-Grenze) des Ladezustands verschoben werden. Führt dagegen der tatsächliche Fahrzeugeinsatz zu einem tatsächlichen Alterungszustand der Batterie, der größer als der erwartete Alterungszustand ist, kann die untere lebensdaueroptimale Grenze des Ladezustands so verschoben werden, dass diese weiter von der 0%-Grenze des Ladezustands entfernt ist, und die obere lebensdaueroptimale Grenze des Ladezustands so verschoben werden, dass diese weiter von der 100%-Grenze des Ladezustands entfernt ist.

Eine Anpassung der Unterteilungsgrenzen kann aber auch durch andere vorausschauende Größen getriggert werden, wie z. B. eine aus der aktuellen Fahrgeschwindigkeit berechnete, voraussichtliche Energierückgewinnung bei einer zukünftigen Bremsung. Beispielsweise kann im Betrieb des Hybridfahrzeugs in Abhängigkeit von einer momentanen Fahrzeuggeschwindigkeit eine voraussichtliche Energierekuperation bei einer zukünftigen Bremsung des Hybridfahrzeugs bestimmt werden und zumindest eine der Unterteilungsgrenzen im Betrieb des Fahrzeugs in Abhängigkeit von der bestimmten Energierekuperation angepasst werden. Beispielsweise kann eine variabel festlegbare Ladegrenze, die einen Ladezustand des Energiespeichers angibt, bei dessen Überschreitung keine Betriebsarten ausgewählt werden, bei denen der Energiespeicher durch Kraftstoffaufwand weiter geladen wird, gesenkt werden, d. h. weiter hin zur 0%-Grenze des Ladezustands verschoben werden, falls die voraussichtliche Energierekuperation einen vorbestimmten ersten Schwellenwert überschreitet, und erhöht werden, falls die voraussichtliche Energierekuperation einen vorbestimmten zweiten Schwellenwert unterschreitet.

Im Rahmen der Erfindung umfasst die mindestens eine Kennlinie eine Kennlinie, die eine Obergrenze für den Kraftstoffmassendurchsatz in Abhängigkeit von dem Ladezustand des Energiespeichers angibt. Die Kennlinie gibt somit einen gewünschten Maximalkraftstoffmassendurchsatz an. Mit dieser Kennlinie kann der Einsatz des Verbrennungsmotors in Abhängigkeit vom momentanen Ladezustand des Energiespeichers priorisiert werden. Beispielsweise sollen bei höheren Ladezuständen eher Betriebspunkte oder Betriebsarten ausgewählt werden, die einen geringen Kraftstoffmassendurchsatz zur Folge haben.

Zudem oder alternativ umfasst die mindestens eine Kennlinie eine Kennlinie, die die Soll-Leistung des elektrischen Energiespeichers in Abhängigkeit von dem Ladezustand des Energiespeichers darstellt. Mit dieser Kennlinie kann der Einsatz der elektrischen Maschine in Abhängigkeit vom momentanen Ladezustand des Energiespeichers priorisiert werden. Beispielsweise sollen bei höheren Ladezuständen eher Betriebsunkte oder Betriebsarten ausgewählt werden, die eine hohe Batterie-(Entlade-)-Leistung zur Folge haben.

Eine an sich bekannte Unterteilungsgrenze des Energiespeichers kann die untere Ladezustandsgrenze (0%-SOC-Grenze) sein, die einen Ladezustand des Energiespeichers kennzeichnet, ab dem der Energiespeicher nach außen hin vollständig entladen ist. Eine weitere an sich bekannte Unterteilungsgrenze des Energiespeichers kann die obere Ladezustandsgrenze (100%-SOC-Grenze) sein, die einen Ladezustand des Energiespeichers kennzeichnet, ab dem der Energiespeicher nach außen hin vollständig geladen ist. Diese beiden Unterteilungsgrenzen sind vorzugsweise nicht variabel.

Ausführungsbeispiele für Unterteilungsgrenzen des Energiespeichers, die vorteilhafterweise im Betrieb des Fahrzeugs in Abhängigkeit von Betriebsparametern variabel festlegbar sind bzw. online variabel festgelegt werden, werden nachfolgend beschrieben:
Eine Unterteilungsgrenze kann eine lebensdaueroptimale Untergrenze des Ladezustands des Energiespeichers sein, welche eine Ladezustandsgrenze kennzeichnet, die aus Lebensdauergründen nicht unterschritten werden sollte und so gewählt ist, dass der Energiespeicher bei Nichtunterschreitung dieser Ladezustandsgrenze über eine Soll-Lebensdauer des Energiespeichers hinweg sicher betrieben werden kann.

Eine Unterteilungsgrenze kann eine lebensdaueroptimale Obergrenze des Ladezustands des Energiespeichers sein, die eine Ladezustandsgrenze kennzeichnet, die aus Lebensdauergründen nicht überschritten werden sollte und so gewählt ist, dass der Energiespeicher bei Nichtüberschreitung dieser Ladezustandsgrenze über eine Soll-Lebensdauer des Energiespeichers hinweg sicher betrieben werden kann.

Die Festlegung einer lebensdaueroptimalen Obergrenze und Untergrenze des Ladezustands ermöglicht die Realisierung von Betriebsstrategien, um den Energiespeicher durch einen Über- und Unterladeschutz vor zu schneller Alterung zu schützen. In die Berechnung dieser Grenzen können unter anderem der aktuelle Alterungszustand (engl. State of Health (SOH)) des elektrischen Energiespeichers und der bisherige Energiedurchsatz seit Inbetriebnahme des Energiespeichers einfließen.

Gemäß einem zweiten Gesichtspunkt der Erfindung wird ein Verfahren zur Auswahl einer Betriebsart eines hybridisierten Antriebsstrangs und/oder zur Bestimmung eines Betriebspunktes des hybridisierten Antriebsstrangs eines Hybridfahrzeugs bereitgestellt. Das Verfahren umfasst hierbei ein Verfahren zur Online-Adaption mindestens einer Kennlinie des Hybridfahrzeugs, wie in den Ansprüchen 1 bis 4 definiert und in den vorhergehenden Absätzen zudem erläutert.

Eine vorteilhafte Ausführungsvariante des Verfahrens sieht hierbei vor, dass die mehreren Unterteilungsgrenzen eine im Betrieb des Fahrzeugs in Abhängigkeit von Betriebsparametern variabel festlegbare Entladegrenze aufweisen, die einen Ladezustand des Energiespeichers angibt, bei dessen Unterschreitung gemäß dem Verfahren zur Auswahl einer Betriebsart nur Betriebsarten ausgewählt werden, die den Energiespeicher nicht entladen. Beispiele für solche Betriebsarten sind ein rein verbrennungsmotorischer Betrieb oder eine Lastpunktanhebung, bei der der Verbrennungsmotor sowohl die Leistung zur vollständigen Erfüllung des positiven Fahrerwunschmomentes als auch zum gleichzeitigen Laden des Traktionsenergiespeichers bereitstellt.

Eine weitere vorteilhafte Ausführungsvariante des Verfahrens sieht hierbei vor, dass die mehreren Unterteilungsgrenzen eine im Betrieb des Fahrzeugs in Abhängigkeit von Betriebsparametern variabel festlegbare Ladegrenze aufweisen, die einen Ladezustand des Energiespeichers angibt, bei dessen Überschreitung keine Betriebsarten ausgewählt werden, bei denen der Energiespeicher durch Kraftstoffaufwand weiter geladen wird.

Die Erfindung betrifft zudem eine Vorrichtung nach Anspruch 8.

Die Erfindung betrifft ferner ein Kraftfahrzeug, insbesondere ein Nutzfahrzeug, nach Anspruch 9.

Zusammengefasst wird mit der Erfindung ein Verfahren zur Online-Adaption mindestens einer Kennlinie eines Hybridfahrzeugs bereitgestellt, bei dem der Ladezustand des Energiespeichers als zentrale Größe einer Betriebsstrategie und fixer Ausgangspunkt für die Entwicklung der weiteren Kenngrößen einer Betriebsstrategie identifiziert wird. Die Aufteilung des gesamten Ladezustands in verschiedene Bereiche schafft eine gemeinsame Struktur für alle Kennlinien der Betriebsstrategie und stellt damit ein Hilfsmittel zur Applizierung der Kennlinien dar. Die Möglichkeit, die Kennlinien an eine gemeinsame Struktur anzupassen, vermindert die Komplexität durch die Strukturierung der Abhängigkeiten und schafft eine konsistente Logik unter den verschiedenen Kennlinien. Die Applizierung der Betriebsstrategie wird dadurch erleichtert. Die Struktur bietet somit eine einfache Möglichkeit, eine Online-adaption der Kennlinien aufgrund veränderter Randbedingungen oder vorausschauender Informationen vorzunehmen.

Weitere Einzelheiten und Vorteile der Erfindung werden im Folgenden unter Bezug auf die beigefügten Zeichnungen beschrieben. Es zeigen:
- Figur 1: ein Ablaufdiagramm zur Illustration der Schritte eines Verfahrens zur Online-Adaption einer Kennlinie gemäß einer Ausführungsform der Erfindung;
- Figur 2: eine beispielhafte Unterteilung des Ladezustandsbereichs des Energiespeichers in mehrere Bereiche; und
- Figur 3: einen beispielhaften Verlauf zweier Kennlinien; und
- Figur 4: den adaptierten Verlauf der Kennlinien aus Figur 3 nach einer Verschiebung einer Unterteilungsgrenze.

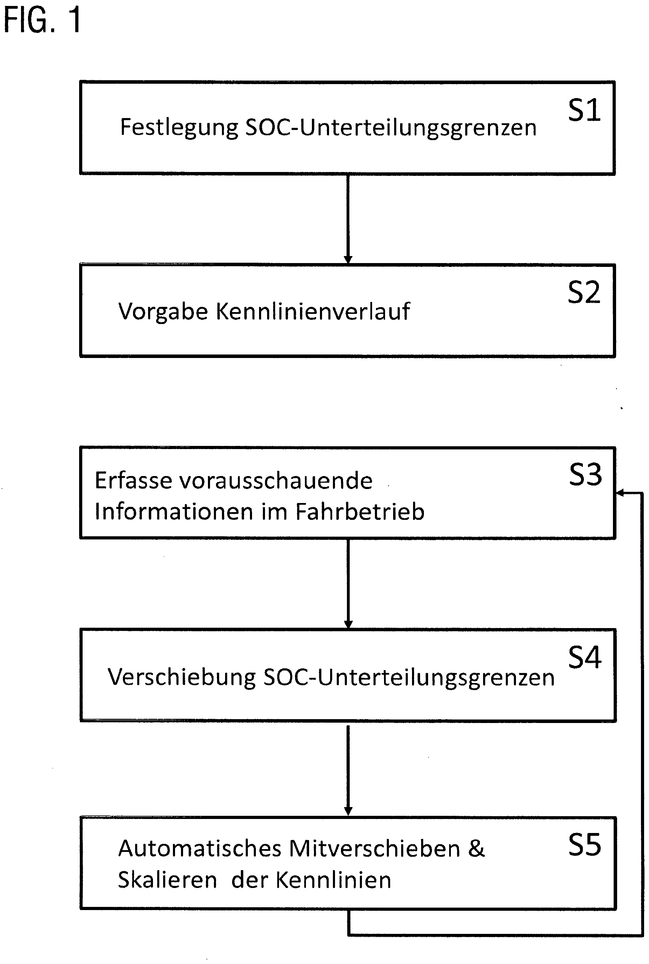

Figur 1 zeigt ein beispielhaftes Ablaufdiagramm zur Illustration der Schritte eines Verfahrens zur Online-Adaption einer Kennlinie gemäß einer Ausführungsform der Erfindung.

Das Verfahren betrifft ein Hybridfahrzeug, das somit einen hybridisierten Antriebsstrang aufweist, mit einem Verbrennungsmotor und einem elektrischen Antrieb, wobei der elektrische Antrieb aus einem Energiespeicher für elektrische Energie (elektrischer Energiespeicher) mit Strom speisbar ist.

Die Schritte S1 und S2 erfolgen "offline", d. h. nicht im Fahrbetrieb des Fahrzeugs, sondern bereits vor oder bei der programmtechnischen Einrichtung der Fahrzeugsteuerung, die zum Ausführen des Online-Verfahrens ausgebildet ist.

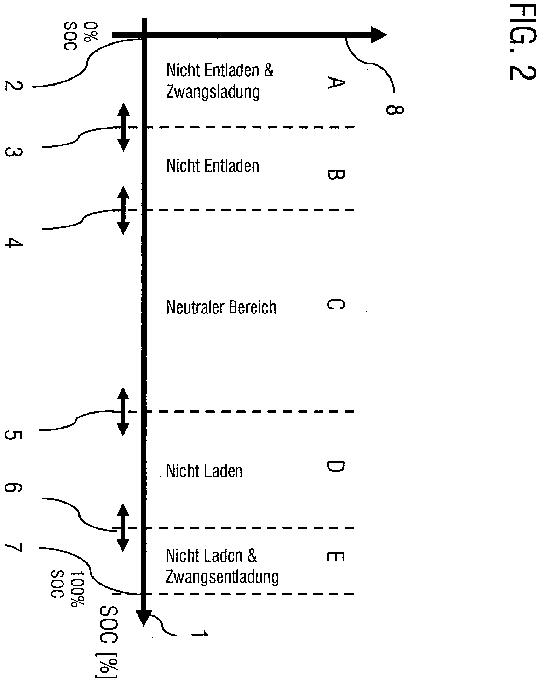

In Schritt S1 werden mehrere Unterteilungsgrenzen, nachfolgend auch kurz als Grenzen bezeichnet, zur Unterteilung eines Ladezustandsbereichs (SOC-Bereich) des elektrischen Energiespeichers festgelegt. Die ist in Figur 2 schematisch und beispielhaft dargestellt. Gleiche oder funktional äquivalente Elemente sind in allen Figuren mit denselben Bezugszeichen bezeichnet.

Die Abszissenachse gibt die Ladezustandsachse (SOC-Achse) 1 an. Der Ladezustandsbereich erstreckt sich von 0 % bis 100 %.

Wie in Figur 2 erkennbar, wurden mehrere Unterteilungsgrenzen 2 bis 7 zur Unterteilung des Ladezustandsbereichs des Energiespeichers in die Bereiche A bis E festgelegt. Der Bereich A erstreckt sich zwischen den Grenzen 2 und 3, der Bereich B zwischen den Grenzen 3 und 4 usw. Die Grenzen 2 und 7 sind nicht variabel. Die Grenze 2 stellt dabei die untere Ladezustandsgrenze 2 dar, die einen Ladezustand des Energiespeichers kennzeichnet, ab dem der Energiespeicher nach außen hin vollständig entladen ist, d. h., der Ladezustand (SOC) beträgt 0 %. Die Grenze 7 stellt dagegen die obere Ladezustandsgrenze 7 dar, die einen Ladezustand des Energiespeichers kennzeichnet, ab dem der Energiespeicher nach außen hin vollständig geladen, d. h., der Ladezustand (SOC) beträgt 100 %.

Dagegen sind die Grenzen 3 bis 6 im Betrieb des Fahrzeugs variabel festlegbar, d. h., die Grenzen 3 bis 6 können entlang der Ladezustandsachse 1 nach links oder rechts verschoben werden, was durch die schwarzen Doppelpfeile schematisch dargestellt ist. Die Anpassung der Grenzen im Fahrbetrieb wird nachfolgend noch erläutert.

Die Grenze 3 stellt eine lebensdaueroptimale Untergrenze dar. Diese Grenze kennzeichnet einen Ladezustand des elektrischen Energiespeichers, der aus Lebensdauergründen nicht unterschritten werden sollte. Die Grenze wird so gewählt, dass der Energiespeicher bei Berücksichtigung dieser Limitierung über seine geplante Lebensdauer hinweg sicher betrieben werden kann. In die Berechnung dieser Grenze können unter anderem z.B. der aktuelle Alterungszustand (State of Health (SoH)) und der bisherige Energiedurchsatz einfließen.

Die Grenze 4 stellt eine Entladegrenze dar. Diese Grenze beschreibt einen Ladezustand, unterhalb dem durch die Betriebsstrategie keine den Energiespeicher entladende Betriebsart ausgewählt werden darf. Ein weiteres Entladen ist also durch die Betriebsstrategie nicht möglich, jedoch ist z. B. durch elektrische Nebenverbraucher ein weiteres Entladen des elektrischen Energiespeichers denkbar.

Die Grenze 5 stellt eine Ladegrenze dar. Diese Grenze beschreibt einen Ladezustand, oberhalb dem der Energiespeicher durch Kraftstoffaufwand nicht weiter geladen werden soll. Ein Überschreiten dieser Grenze ist also nur möglich, wenn die Energie auf anderem Weg, z. B. durch Bremsrekuperation, erzeugt wird.

Die Grenze 6 stellt eine lebensdaueroptimale Obergrenze dar. Diese Grenze kennzeichnet einen Ladezustand, der aus Lebensdauergründen nicht überschritten werden sollte. Die Grenze wird so gewählt, dass der Energiespeicher bei Berücksichtigung dieser Limitierung über seine geplante Lebensdauer hinweg sicher betrieben werden kann. In die Berechnung dieser Grenze können unter anderem z. B. der aktuelle Alterungszustand und der bisherige Energiedurchsatz einfließen.

Mit den beispielhaft genannten Grenzen können über den gesamten Ladezustandsbereich verschiedene Betriebsbereiche A bis E definiert werden:
Innerhalb des Bereichs A darf von der Betriebsstrategie keine entladende Betriebsart ausgewählt werden. Gleichzeitig muss, wenn möglich, der Speicher zwanghaft geladen werden. Innerhalb des Bereichs B darf von der Betriebsstrategie keine entladende Betriebsart ausgewählt werden. Gleichzeitig wird die Möglichkeit bereitgestellt, dass sich die Betriebsstrategie gegen ein Laden unter Kraftstoffaufwand entscheidet. Der Bereich C stellt den neutralen Bereich dar. In diesem Bereich können sowohl den Energiespeicher entladende als auch den Energiespeicher ladende Betriebsarten ausgewählt werden. Innerhalb des Bereichs D darf von der Betriebsstrategie keine Betriebsart ausgewählt werden, die den Speicher unter Kraftstoffaufwand lädt. Gleichzeitig wird die Möglichkeit bereitgestellt, dass sich die Betriebsstrategie gegen eine entladende Betriebsart entscheidet. Innerhalb des Bereichs E darf von der Betriebsstrategie keine ladende Betriebsart ausgewählt werden. Gleichzeitig muss, wenn möglich, der Speicher zwanghaft entladen werden.

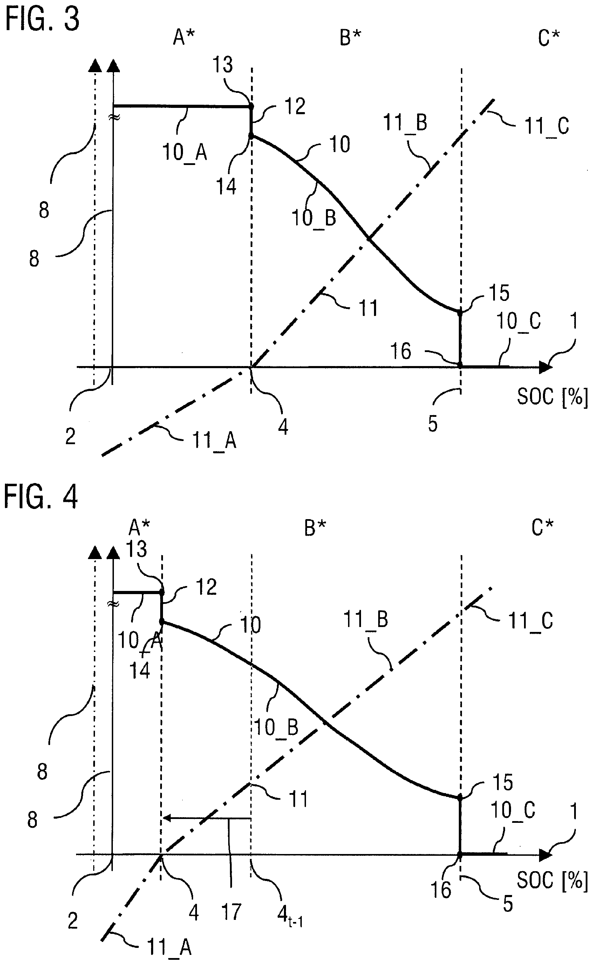

Je nachdem in welchem Bereich A bis E sich der Ladezustand momentan befindet, stehen der Betriebsstrategie somit unterschiedliche Betriebsarten und/oder Betriebspunkte zur Auswahl zur Verfügung, was nachfolgend noch anhand der Figuren 3 und 4 näher erläutert wird.

Die über dem Ladezustandsbereich definierten Grenzen 2 bis 7 und Bereiche A bis E stellen ein Hilfsmittel dar, mit dem die Kennlinien einer Betriebsstrategie aneinander angepasst werden können. Jede Kennlinie muss sich derart an den Grenzen orientieren, dass die erwünschten Effekte der Bereiche sichergestellt werden. Dadurch haben alle Kennlinien des Verfahrens einen gemeinsamen Rahmen, an den sie angepasst werden können. Dadurch sinkt die Komplexität bei Abhängigkeiten zwischen den Kennlinien.

Wie in Figur 1 dargestellt, werden nach Festlegung der Unterteilungsgrenzen die Kennlinienverläufe in Abhängigkeit vom Ladezustand des Energiespeichers festgelegt.

Dies ist in Figur 3 beispielhaft für zwei Kennlinien dargestellt. Im Unterschied zum Beispiel der Figur 2 weist der Ladezustandsbereich in Figur 3 nicht die Unterteilungsgrenze 3 auf. Die verschiebbare Unterteilungsgrenze 4 entspricht der vorstehend beschriebenen Entladegrenze. Die dadurch entstehenden Bereich A*, B*, C* des Ladezustandsbereichs entsprechen somit auch nicht den Bereichen der Figur 2 und sind daher mit einem "*" gekennzeichnet. In Figur 3 ist zur Vereinfachung der Darstellung nur ein Ausschnitt des Ladezustandsbereichs darstellt.

Eine erste Kennlinie, deren Verlauf durch die durchgezogene Linie 10 dargestellt ist, gibt den gewünschten Maximalkraftstoffmassendurchsatz (rechte Y-Achse 8) an. Der vorgegebene Verlauf 10 der Kennlinie setzt sich aus den Teilverläufen 10_A, 10_B und 10_C zusammen, die sich jeweils von einer Unterteilungsgrenze zu einer hierzu benachbarten Unterteilungsgrenze erstrecken. Der Teilverlauf 10_A erstreckt sich von der unteren Ladezustandsgrenze 2 bis zur Entladegrenze 4 des Ladezustands. Der Teilverlauf 10_B erstreckt sich von der Entladegrenze 4 bis zur Ladegrenze 5, usw.

Bei höheren Ladezuständen sollen eher Betriebsarten ausgewählt werden, die einen geringen Kraftstoffmassendurchsatz zur Folge haben. Folglich weist der Teilverlauf 10B eine negative Steigung auf. An der oberen Unterteilungsgrenze 5 erfolgt ein Sprung auf null. Unterhalb der Entladegrenze 4 sollen die Grenzen für den Kraftstoffmassendurchsatz völlig geöffnet werden, um den Kraftstoffmassendurchsatz nicht zu begrenzen. Im Punkt 14 springt der Kennlinienverlauf (Abschnitt 12 der Kennlinie) auf unendlich oder einen hohen Wert, der den Kraftstoffmassendurchsatz praktisch nicht begrenzt (Verlauf 10_A).

Eine zweite Kennlinie, deren Verlauf durch die strichgepunktete Linie 11 dargestellt ist, gibt die Soll-Batterieleistung des Energiespeichers an (linke Y-Achse 8). Bei höheren Ladezuständen sollen eher Betriebspunkte ausgewählt werden, die eine hohe Batterie-(Entlade-) Leistung zur Folge haben, weswegen die Kennlinie ansteigt. Unterhalb der Entladegrenze 4 soll der Speicher eher geladen statt entladen werden, so dass sich im Bereich A* eine negative Sollbatterieleistung ergibt.

Der Verlauf der Kennlinien wird an den Unterteilungsgrenzen 4,5 fest vorgegeben, d. h., die Ordinaten derjenigen Kennlinienpunkten 13, 14, 15, 16, deren Abszisse, d. h. Position auf der Ladezustandsachse, mit der Position einer Unterteilungsgrenze 4,5 übereinstimmt, werden fix vorgeben. Dadurch sind Kennlinienwerte an den Stellen der Unterteilungsgrenzen fest vorgeben, unabhängig von der momentanen Position einer variablen festlegbaren Unterteilungsgrenze. Mit anderen Worten können sich die Punkte 13 bis 16 zwar in Abszissenrichtung 1 verschieben, falls sich die Unterteilungsgrenze verschiebt, ihre Ordinate, d. h. der Wert auf der Achse 8, bleibt aber immer gleich.

Die Schritte S3 bis S5 werden fortlaufend im Fahrbetrieb des Hybridfahrzeugs durchlaufen.

Im Fahrbetrieb des Fahrzeugs können sich nun die Unterteilungsgrenzen verschieben, wodurch die Kennlinien automatisch adaptiert werden.

Hierzu werden in Schritt S3 im Fahrbetrieb fortlaufend vorausschauende Informationen erfasst. Beispielsweise wird fortlaufend das Höhenprofil des vorausliegenden Streckenabschnitts des Fahrzeugs durch Auswertung von Topografiedaten bestimmt.

In Schritt S4 wird dann in Abhängigkeit von dem bestimmten Höhenprofil geprüft, ob eine Verschiebung der Unterteilungsgrenzen vorgenommen werden soll. Wird dabei beispielsweise festgestellt, dass sich das Fahrzeug einer längeren Gefällestrecke nähert, in der eine längere Rekuperationsphase möglich ist, wird die Entladegrenze 4 nach links verschoben und auf einen kleineren Ladezustandswert eingestellt. Dies ist in Figur 4 dargestellt. Die neue aktuelle Entladegrenze 4 wurde um den Betrag, der der Länge des Pfeils 17 entspricht, nach links verschoben. Die alte Entladegrenze ist in Figur 4 mit 4ₜ₋₁ bezeichnet.

In Schritt S5 wird dann der Verlauf der Kennlinien automatisch adaptiert. Die auf der verschobenen Entladegrenze liegenden Kennlinienpunkte 13 und 14 wandern mit der Entladegrenze 4 mit und werden um den gleichen Betrag nach links verschoben. Dadurch werden die Verläufe 10A und 11A der Kennlinien entsprechend in Abszissenrichtung 1 gestaucht. Gleichzeitig werden die Verläufe 10B und 10C der Kennlinie entsprechend in Abszissenrichtung 1 gestreckt. Die Verläufe 10C und 11C sind unverändert.

Die dynamische Online-Anpassung der Kennlinien erfolgt somit durch Anpassung der Kennlinien an die verschobenen Unterteilungsgrenzen. Die Kennlinien wandern mit diesen Grenzen mit und werden automatisch entsprechend skaliert. Die über dem Ladezustand (SOC) definierten Unterteilungsgrenzen und dadurch gebildeten Ladezustandsbereiche stellen einen Bezugsrahmen dar, mit dem die Kennlinien einer Betriebsstrategie aneinander angepasst werden können.

### Bezugszeichenliste

- 1: Ladezustandsverlauf/Ladezustandsachse/Abszissenrichtung
- 2: Untere Ladezustandsgrenze
- 3: Lebensdaueroptimale Untergrenze
- 4: Entladegrenze
- 5: Ladegrenze
- 6: Lebensdaueroptimale Obergrenze
- 7: Obere Ladezustandsgrenze
- 8: Koordinatenachse der Kennlinie
- 10: Kennlinienverlauf
- 10_A, 10_B, 10_C: Kennlinienteilverläufe
- 11: Kennlinienverlauf
- 11_A, 11_B, 11_C: Kennlinienteilverläufe
- 12: Kennliniensprung
- 13-16: Auf den Unterteilungsgrenzen liegende Kennlinienpunkte

## Patentansprüche

1. Verfahren zur Online-Adaption mindestens einer Kennlinie eines Hybridfahrzeugs, aufweisend einen hybridisierten Antriebsstrang mit einem elektrischen Antrieb, welcher aus einem elektrischen Energiespeicher mit Strom speisbar ist, wobei die mindestens eine Kennlinie zur Auswahl einer Betriebsart und/oder zur Bestimmung eines Betriebspunktes des hybridisierten Antriebsstrangs des Hybridfahrzeugs verwendet wird, umfassend die Schritte:
- Festlegung mehrerer Unterteilungsgrenzen (2-7) zur Unterteilung eines Ladezustandsbereichs (1) des Energiespeichers in mehrere Bereiche (A-E), wobei zumindest eine der Unterteilungsgrenzen (3-6) im Betrieb des Fahrzeugs variabel festlegbar ist (S1); und
- Vorgabe eines Verlaufs (10, 11) der mindestens einen Kennlinie in Abhängigkeit von einem Ladezustand des Energiespeichers, wobei die Werte (13-16) der mindestens einen Kennlinie an den Unterteilungsgrenzen (2-7) fest vorgegeben werden (S2); und
- Online-Adaption der mindestens einen Kennlinie im Falle einer Verschiebung der zumindest einen variablen Unterteilungsgrenze (3-6), wobei die mindestens eine Kennlinie unter Berücksichtigung der fest vorgegebenen Werte (13-16) an den Unterteilungsgrenzen (2-7) und korrespondierend zu der zumindest einen verschobenen variablen Unterteilungsgrenze (3-6) verschoben und skaliert wird (S4, S5);
**dadurch gekennzeichnet,**
a1) dass zumindest eine der Unterteilungsgrenzen im Betrieb des Fahrzeugs fortlaufend in Abhängigkeit von Informationen, die einen vorausliegenden Streckenabschnitt kennzeichnen, angepasst wird; und/oder
a2) dass zumindest eine der Unterteilungsgrenzen im Betrieb des Fahrzeugs fortlaufend in Abhängigkeit von topographischen Daten eines vorausliegenden Streckenabschnitts, die einen Gefälle- und Steigungsverlauf des vorausliegenden Streckenabschnitts angeben, angepasst wird; und
dass die mindestens eine Kennlinie eine Kennlinie umfasst,
b1) die eine Obergrenze für den Kraftstoffmassendurchsatz in Abhängigkeit von dem Ladezustand des Energiespeichers angibt; und/oder
b2) die eine Soll-Leistung des elektrischen Energiespeichers in Abhängigkeit von dem Ladezustand des Energiespeichers angibt.

2. Verfahren nach Anspruch 1, **dadurch gekennzeichnet,**
(a) **dass** der vorgegebene Verlauf (10, 11) jeder der mindestens einen Kennlinie durch mehrere Teilverläufe (10_A, 10_B, 10_C, 11_A, 11_B, 11_C) gebildet wird, die sich jeweils von einer Unterteilungsgrenze (2-7) zu einer hierzu benachbarten Unterteilungsgrenze (2-7) erstrecken; und
(b) **dass** sich ein adaptierter Verlauf der Kennlinie im Falle der Verschiebung (17) der zumindest einen (3) variablen Unterteilungsgrenze (3-6) durch eine Streckung, Stauchung und/oder Verschiebung in Abszissenrichtung (1) der Kennlinie derjenigen Teilverläufe (10_A, 10_B, 11_A, 11_B) ergibt, die an der zumindest einen Unterteilungsgrenze (4) enden, die verschoben wurde, wobei ein Randpunkt (15, 16) eines Teilverlaufs durch die Streckung, Stauchung und/oder Verschiebung in Abszissenrichtung unverändert bleibt, falls er auf einer nicht verschobenen Unterteilungsgrenze (7) liegt oder in Abszissenrichtung zusammen mit der Unterteilungsgrenze (4) verschoben wird, falls er (13, 14) auf der verschobenen Unterteilungsgrenze (4) liegt.

3. Verfahren nach einem der vorhergehenden Ansprüche, **dadurch gekennzeichnet, dass** die mehreren Unterteilungsgrenzen umfassen:
(a) eine untere Ladezustandsgrenze (2), die einen Ladezustand des Energiespeichers kennzeichnet, ab dem der Energiespeicher nach außen hin vollständig entladen ist; und
b) eine obere Ladezustandsgrenze (7), die einen Ladezustand des Energiespeichers kennzeichnet, ab dem der Energiespeicher nach außen hin vollständig geladen ist.

4. Verfahren nach einem der vorhergehenden Ansprüche, **dadurch gekennzeichnet, dass** die mehreren Unterteilungsgrenzen zumindest eine der folgenden Unterteilungsgrenzen umfassen, die im Betrieb des Fahrzeugs in Abhängigkeit von Betriebsparametern variabel festlegbar sind:
(a) eine lebensdaueroptimale Untergrenze (3) des Ladezustands des Energiespeichers, die eine Ladezustandsgrenze kennzeichnet, die aus Lebensdauergründen nicht unterschritten werden sollte und so gewählt ist, dass der Energiespeicher bei Nichtunterschreitung dieser Ladezustandsgrenze über eine Soll-Lebensdauer des Energiespeichers hinweg sicher betrieben werden kann;
(b) eine lebensdaueroptimale Obergrenze (6) des Ladezustands des Energiespeichers, die eine Ladezustandsgrenze kennzeichnet, die aus Lebensdauergründen nicht überschritten werden sollte und so gewählt ist, dass der Energiespeicher bei Nichtüberschreitung dieser Ladezustandsgrenze über eine Soll-Lebensdauer des Energiespeichers hinweg sicher betrieben werden kann.

5. Verfahren zur Auswahl einer Betriebsart eines hybridisierten Antriebsstrangs und/oder zur Bestimmung eines Betriebspunktes des hybridisierten Antriebsstrangs eines Hybridfahrzeugs, umfassend ein Verfahren zur Online-Adaption mindestens einer Kennlinie des Hybridfahrzeugs nach einem der vorhergehenden Ansprüche.

6. Verfahren nach Anspruch 5, **dadurch gekennzeichnet, dass** die mehreren Unterteilungsgrenzen zumindest eine der folgenden Unterteilungsgrenzen umfassen, die im Betrieb des Fahrzeugs in Abhängigkeit von Betriebsparametern variabel festlegbar sind:
(a) eine Entladegrenze (4), die einen Ladezustand des Energiespeichers angibt, bei dessen Unterschreitung nur Betriebsarten ausgewählt werden, die den Energiespeicher nicht entladen, beispielsweise einen rein verbrennungsmotorischen Betrieb oder eine Lastpunktanhebung; und
(b) eine Ladegrenze (5), die einen Ladezustand des Energiespeichers angibt, bei dessen Überschreitung keine Betriebsarten ausgewählt werden, bei denen der Energiespeicher durch Kraftstoffaufwand weiter geladen wird.

7. Verfahren nach einem der vorhergehenden Ansprüche, **dadurch gekennzeichnet,**
(a) **dass** im Betrieb des Hybridfahrzeugs in Abhängigkeit von einer momentanen Fahrzeuggeschwindigkeit eine voraussichtliche Energierekuperation bei einer zukünftigen Bremsung des Hybridfahrzeugs bestimmt wird und zumindest eine der Unterteilungsgrenzen im Betrieb des Fahrzeugs in Abhängigkeit von der bestimmten Energierekuperation angepasst wird; und/oder
(b) **dass** zumindest eine der Unterteilungsgrenzen im Betrieb des Fahrzeugs angepasst wird, falls ein geplanter Fahrzeugeinsatz, für den die Applizierung der Kennlinie vorgenommen wurde, vom tatsächlichen Fahrzeugeinsatz abweicht.

8. Vorrichtung, die eingerichtet ist, das Verfahren gemäß einem der Ansprüche 1 bis 7 durchzuführen.

9. Kraftfahrzeug, insbesondere Nutzfahrzeug, aufweisend einen hybridisierten Antriebsstrang mit einem elektrischen Antrieb und einen elektrischen Energiespeicher, wobei besagter Antrieb aus dem elektrischen Energiespeicher mit Strom speisbar ist, mit einer Vorrichtung nach Anspruch 8

## Claims

1. A method for the online adaptation of at least one characteristic of a hybrid vehicle, comprising a hybridized drive train with an electric drive that can be supplied with electricity from an electrical energy storage arrangement, wherein the at least one characteristic is used for the selection of an operating mode and/or for determining an operating point of the hybridized drive train of the hybrid vehicle, comprising the steps of:
- establishing a plurality of partition boundaries (2-7) for dividing a range of states of charge (1) of the energy storage arrangement into a plurality of regions (A-E), wherein at least one of the partition boundaries (3-6) can be variably determined (S1) during the operation of the vehicle; and
- predetermining a profile (10, 11) of the at least one characteristic depending on a state of charge of the energy storage arrangement, wherein the values (13-16) of the at least one characteristic at the partition boundaries (2-7) are fixedly predetermined (S2); and
- online adaptation of the at least one characteristic in the case of a shift of the at least one variable partition boundary (3-6), wherein the at least one characteristic is shifted and scaled (S4, S5) taking into account the fixedly predetermined values (13-16) at the partition boundaries (2-7) and corresponding to the at least one shifted variable partition boundary (3-6),
**characterized**
a1) in that at least one of the partition boundaries is adapted continuously during the operation of the vehicle depending on information characterizing a segment of route ahead; and/or
a2) in that at least one of the partition boundaries is continuously adapted during the operation of the vehicle depending on topographical data of a segment of route ahead indicating a decline profile and an incline profile of the segment of route ahead; and
in that the at least one characteristic comprises a characteristic
b1) that specifies an upper boundary for the fuel mass throughput depending on the state of charge of the energy storage arrangement; and/or
b2) that specifies a nominal performance of the electrical energy storage arrangement depending on the state of charge of the energy storage arrangement.

2. The method according to Claim 1, **characterized**
(a) **in that** the predetermined profile (10, 11) of each of the at least one characteristics is formed by a plurality of sub profiles (10_A, 10_B, 10_C, 11_A, 11_B, 11_C), each of which extends from a partition boundary (2-7) to a partition boundary (2-7) that is adjacent thereto; and
(b) **in that** an adapted profile of the characteristic results in the event of a shift (17) of the at least one (3) variable partition boundary (3-6) by an extension, compression and/or shift in the abscissa direction (1) of the characteristic of those sub profiles (10_A, 10_B, 11_A, 11_B) that end at at least one partition boundary (4) that has been shifted, wherein a boundary point (15, 16) of a subprofile remains unchanged during the extension, compression and/or shift in the abscissa direction if it lies on a non-shifted partition boundary (7) or is shifted in the abscissa direction together with the partition boundary (4) if it (13, 14) lies on a shifted partition boundary (4).

3. The method according to one of the preceding claims, **characterized in that** the plurality of partition boundaries includes:
(a) a lower state of charge boundary (2) that identifies a state of charge of the energy storage arrangement from which the energy storage arrangement is outwardly fully discharged; and
(b) an upper state of charge boundary (7) that identifies a state of charge of the energy storage arrangement from which the energy storage arrangement is outwardly full charged.

4. The method according to one of the preceding claims, **characterized in that** the plurality of partition boundaries includes at least one the following partition boundaries that can be variably determined during the operation of the vehicle as a function of operating parameters:
(a) a lower boundary (3) of the state of charge of the energy storage arrangement that is optimal for the service life, that identifies a state of charge boundary below which the state of charge should not lie for service life reasons and that is selected so that the energy storage arrangement can be safely operated over a nominal service life of the energy storage arrangement if the state of charge does not fall below said state of charge boundary;
(b) an upper boundary (6) of the state of charge of the energy storage arrangement that is optimal for the service life, that identifies a state of charge boundary that should not be exceeded for service life reasons and that is selected so that the arrangement can be safely operated over a nominal service life of the energy storage arrangement if said state of charge boundary is not exceeded.

5. A method for the selection of an operating mode of a hybridized drive train and/or for determining an operating point of the hybridized drive train of a hybrid vehicle, comprising a method for the online adaptation of at least one characteristic of the hybrid vehicle according to one of the preceding claims.

6. The method according to Claim 5, **characterized in that** the plurality of partition boundaries includes at least one of the following partition boundaries that can be variably determined during the operation of the vehicle as a function of operating parameters:
(a) a discharge boundary (4) that indicates a state of charge of the energy storage arrangement, wherein if the state of charge is below said limit only operating modes in which the energy storage arrangement is not discharged are selected, for example a solely combustion engine mode or a load point increase; and
(b) a charging boundary (5) that indicates a state of charge of the energy storage arrangement, wherein if the limit is exceeded no operating modes in which the energy storage arrangement is charged further by consuming fuel are selected.

7. The method according to one of the preceding claims, **characterized in that,**
(a) during the operation of the hybrid vehicle a probable energy recovery during a future braking process of the hybrid vehicle is determined as a function of a current speed of the vehicle and at least one of the partition boundaries is adapted during the operation of the vehicle depending on the determined energy recovery; and/or
(b) at least one of the partition boundaries is adapted during the operation of the vehicle if a planned use of the vehicle for which the application of the characteristic has been carried out deviates from the actual use of the vehicle.

8. A device that is arranged to perform the method according to one of Claims 1 to 7.

9. A motor vehicle, in particular a commercial vehicle, comprising a hybridized drive train with an electric drive and an electrical energy storage arrangement, wherein said drive can be supplied with electricity from the electrical energy storage arrangement, with a device according to Claim 8.

## Revendications

1. Procédé d'adaptation en ligne d'au moins une courbe caractéristique d'un véhicule hybride, présentant une chaîne cinématique hybridée dotée d'un entraînement électrique qui peut être alimenté en courant à partir d'un accumulateur d'énergie électrique, ladite au moins une courbe caractéristique étant utilisée pour sélectionner un mode de fonctionnement et/ou pour déterminer un point de fonctionnement de la chaîne cinématique hybridée du véhicule hybride, comprenant les étapes consistant à :
- fixer plusieurs limites de subdivision (2 à 7) pour subdiviser une plage d'état de charge (1) de l'accumulateur d'énergie en plusieurs plages (A à E), au moins l'une des limites de subdivision (3 à 6) pouvant être fixée de manière variable (S1) en cours de fonctionnement du véhicule ; et
- spécifier un tracé (10, 11) de ladite au moins une courbe caractéristique en fonction d'un état de charge de l'accumulateur d'énergie, les valeurs (13 à 16) de ladite au moins une courbe caractéristique étant spécifiées de manière fixe (S2) aux limites de subdivision (2 à 7) ; et
- adapter en ligne ladite au moins une courbe caractéristique dans le cas d'un décalage de ladite au moins une limite de subdivision variable (3 à 6), ladite au moins une courbe caractéristique étant décalée et mise à l'échelle (S4, S5) en tenant compte des valeurs spécifiées de manière fixe (13 à 16) aux limites de subdivision (2 à 7) et en correspondance avec ladite au moins une limite de subdivision variable décalée (3 à 6) ;
caractérisé
a1) en ce qu'au moins l'une des limites de subdivision est adaptée en cours de fonctionnement du véhicule en continu en fonction d'informations qui caractérisent un tronçon de route à venir ; et/ou
a2) en ce qu'au moins l'une des limites de subdivision est adaptée en cours de fonctionnement du véhicule en continu en fonction de données topographiques d'un tronçon de route à venir qui indiquent un tracé de descente et de montée du tronçon de route à venir ; et
en ce que ladite au moins une courbe caractéristique comprend une courbe caractéristique
b1) qui indique une limite supérieure au débit massique de carburant en fonction de l'état de charge de l'accumulateur d'énergie ; et/ou
b2) qui indique une puissance théorique de l'accumulateur d'énergie électrique en fonction de l'état de charge de l'accumulateur d'énergie.

2. Procédé selon la revendication 1, **caractérisé**
a) **en ce que** le tracé spécifié (10, 11) de chacune de ladite au moins une courbe caractéristique est formé par plusieurs tracés partiels (10_A, 10_B, 10_C, 11_A, 11_B, 11_C) qui s'étendent respectivement d'une limite de subdivision (2 à 7) à une limite de subdivision (2 à 7) adjacente à celle-ci ; et
b) **en ce qu'**un tracé adapté de la courbe caractéristique résulte dans le cas du décalage (17) de ladite au moins une (3) limite de subdivision variable (3 à 6) par un étirement, un tassement et/ou une translation dans la direction de l'abscisse (1) de la courbe caractéristique de ceux des tracés partiels (10_A, 10_B, 11_A, 11_B) qui se terminent au niveau de ladite au moins une limite de subdivision (4) qui a été décalée, un point marginal (15, 16) d'un tracé partiel restant inchangé par l'étirement, le tassement et/ou la translation dans la direction de l'abscisse s'il se trouve sur une limite de subdivision non décalée (7), ou est décalé dans la direction de l'abscisse avec la limite de subdivision (4) s'il se trouve (13, 14) sur la limite de subdivision décalée (4).

3. Procédé selon l'une quelconque des revendications précédentes, **caractérisé en ce que** les plusieurs limites de subdivision comprennent :
a) une limite d'état de charge inférieure (2) qui caractérise un état de charge de l'accumulateur d'énergie à partir duquel l'accumulateur d'énergie est déchargé complètement vis-à-vis de l'extérieur ; et
b) une limite d'état de charge supérieure (7) qui caractérise un état de charge de l'accumulateur d'énergie à partir duquel l'accumulateur d'énergie est chargé complètement vis-à-vis de l'extérieur.

4. Procédé selon l'une quelconque des revendications précédentes, **caractérisé en ce que** les plusieurs limites de subdivision comprennent au moins l'une des limites de subdivision suivantes qui peuvent être fixées de manière variable en cours de fonctionnement du véhicule en fonction de paramètres de fonctionnement :
a) une limite inférieure (3), optimale pour la durée de vie, de l'état de charge de l'accumulateur d'énergie qui caractérise une limite d'état de charge qui ne doit pas être soupassée pour des raisons de durée de vie et est sélectionnée de telle sorte qu'en cas de non soupassement de cette limite d'état de charge, l'accumulateur d'énergie peut fonctionner de façon sûre au-delà d'une durée de vie théorique de l'accumulateur d'énergie ;
b) une limite supérieure (6), optimale pour la durée de vie, de l'état de charge de l'accumulateur d'énergie qui caractérise une limite d'état de charge qui ne doit pas être dépassée pour des raisons de durée de vie et est sélectionnée de telle sorte qu'en cas de non dépassement de cette limite d'état de charge, l'accumulateur d'énergie peut fonctionner de façon sûre au-delà d'une durée de vie théorique de l'accumulateur d'énergie.

5. Procédé de sélection d'un mode de fonctionnement d'une chaîne cinématique hybridée et/ou de détermination d'un point de fonctionnement de la chaîne cinématique hybridée d'un véhicule hybride, comprenant un procédé d'adaptation en ligne d'au moins une courbe caractéristique du véhicule hybride selon l'une quelconque des revendications précédentes.

6. Procédé selon la revendication 5, **caractérisé en ce que** les plusieurs limites de subdivision comprennent au moins l'une des limites de subdivision suivantes qui peuvent être fixées de manière variable en cours de fonctionnement du véhicule en fonction de paramètres de fonctionnement :
a) une limite de décharge (4) qui indique un état de charge de l'accumulateur d'énergie au-dessous duquel sont sélectionnés seuls des modes de fonctionnement qui ne déchargent pas l'accumulateur d'énergie, par exemple un mode uniquement par moteur à combustion ou une augmentation de point de charge ; et
b) une limite de charge (5) qui indique un état de charge de l'accumulateur d'énergie au-dessus duquel aucun mode de fonctionnement n'est sélectionné dans lequel l'accumulateur d'énergie continue d'être chargé par une consommation de carburant.

7. Procédé selon l'une quelconque des revendications précédentes, **caractérisé,**
a) **en ce qu'**en cours de fonctionnement du véhicule hybride, en fonction d'une vitesse de véhicule momentanée, une récupération d'énergie probable lors d'un futur freinage du véhicule hybride est déterminée, et au moins l'une des limites de subdivision est adaptée en cours de fonctionnement du véhicule en fonction de la récupération d'énergie déterminée ; et/ou
b) **en ce qu'**au moins l'une des limites de subdivision est adaptée en cours de fonctionnement du véhicule si une utilisation de véhicule planifiée pour laquelle l'application de la courbe caractéristique a été effectuée dévie par rapport à l'utilisation de véhicule réelle.

8. Dispositif qui est aménagé pour exécuter le procédé selon l'une quelconque des revendications 1 à 7.

9. Véhicule automobile, en particulier véhicule utilitaire, présentant une chaîne cinématique hybridée dotée d'un entraînement électrique et d'un accumulateur d'énergie électrique, ledit entraînement pouvant être alimenté en courant à partir de l'accumulateur d'énergie électrique, comprenant un dispositif selon la revendication 8.
